# EUROPEAN PATENT APPLICATION

(11) **EP 4 683 106 A1**
(43) Date of publication of application: **21.01.2026**
(21) Application number: 24189361.9
(22) Date of filing: 18.07.2024
(51) Int. Cl.: H01P 3/00, G02B 6/02, G01B 11/16, G01K 11/32, H01B 11/18, H04B 3/46

(54) **HYBRID CABLE**

(71) Applicant: Rohde & Schwarz GmbH & Co. KG, 81671 München (DE)
(72) Inventor: STEFFENS, Johannes, 83026 Rosenheim (DE)
(74) Representative: Kehl, Ascherl, Liebhoff & Ettmayr Patentanwälte Partnerschaft mbB

(57) **Abstract**

The present disclosure provides a hybrid cable comprising a first signal port, a second signal port, an RF electrical conductive signal path coupled to the first signal port, and the second signal port, an optical conductive signal path arranged along the RF electrical conductive signal path such that changes of at least one physical parameter of the RF electrical conductive signal path also affect the optical conductive signal path, and a reflector arranged in the first signal port or the second signal port, wherein the optical conductive signal path is coupled to the reflector and to the signal port that is opposite to the signal port that comprises the reflector. Further, the present disclosure provides a respective measurement application device.

## Description

### TECHNICAL FIELD

The disclosure relates to a hybrid cable.

### BACKGROUND

Although applicable to any type of measurement application, the present disclosure will mainly be described in conjunction with RF measurements.

When performing measurements with RF signals calibrating the measurement system is essential for performing high accuracy measurements, especially for those containing frequencies in the GHz range and higher.

However, changing ambient conditions may influence cables used for such measurements to an extent that the measurement accuracy is degraded.

Accordingly, there is a need for improving RF measurements.

### SUMMARY

The above stated problem is solved by the features of the independent claims. It is understood, that independent claims of a claim category may be formed in analogy to the dependent claims of another claim category.

Accordingly, it is provided:
A hybrid cable comprising a first signal port, a second signal port, an RF electrical conductive signal path coupled to the first signal port, and the second signal port, an optical conductive signal path arranged along the RF electrical conductive signal path such that changes of at least one physical parameter of the RF electrical conductive signal path also affect the optical conductive signal path, and a reflector arranged in the first signal port or the second signal port, wherein the optical conductive signal path is coupled to the reflector and to the signal port that is opposite to the signal port that comprises the reflector.

Further, it is provided:
A measurement application device comprising a signal port with an RF interface, and a reference interface, and a calibration parameter determination unit, wherein the signal port is couplable to a hybrid cable according to any one the preceding claims, and wherein the calibration parameter determination unit is configured to determine at least one calibration parameter for an RF signal path coupled to the RF interface of the signal port based on an input signal that is received via the reference interface in response to a calibration signal being output via the reference interface of the signal port.

The present disclosure is based on the finding that the signal transmission characteristics of electrically conductive cables may vary depending on physical properties of the cables. For example, a temperature change of a cable may directly or indirectly, via a length variation, influence the RF signal transmission characteristics of the cable.

The present disclosure, therefore, provides a hybrid cable. The hybrid cable comprises an RF electrical conductive signal path, and combines this RF electrical conductive signal path with an optical conductive signal path.

The RF electrical conductive signal path serves for transmitting an RF signal in the respective application. To this end, the RF electrical conductive signal path is coupled to a first signal port on one end, and to a second signal port on the other end.

The optical conductive signal path is arranged in the hybrid cable along the RF electrical conductive signal path. The optical conductive signal path is arranged in such a way that changes of at least one physical parameter of the RF electrical conductive signal path also affect the optical conductive signal path. The term "affect" in this context is to be understood as the change of the respective physical parameter influencing the optical conductive signal path in such a way that it may be somehow measured via the optical conductive signal path.

The optical conductive signal path, in contrast to the RF electrical conductive signal path, is only coupled on one end either to the first signal port or the second signal port for receiving or outputting a signal in the optical spectrum.

On the other end, the optical conductive signal path is coupled to a reflector, such that the reflector reflects incident signal back into the optical conductive signal path. The reflector is provided in the signal port that is not coupled to the optical conductive signal path for signal transmission. Therefore, the optical conductive signal path follows the full RF electrical conductive signal path from the first signal port to the second signal port.

The optical conductive signal path in the hybrid cable may be seen as a kind of sensor for sensing changes in the ambient parameters surrounding the hybrid cable.

In the hybrid cable, the RF electrical conductive signal path may be accessed on both signal ports, while the optical conductive signal path may be accessed only on one of the signal ports.

By providing access to the optical conductive signal path only on one end of the hybrid cable, the accuracy or resolution of the measurement performed via the optical conductive signal path may be increased e.g., doubled, because the optical conductive signal path is traversed twice by the optical signal.

A respective measurement application device may couple to such a hybrid cable on the end or port that provides access to the optical conductive signal path and the RF electrical conductive signal path. The signal port of the measurement application device comprises the RF interface to couple to the RF electrical conductive signal path via a respective signal port of the hybrid cable. The signal port further comprises a reference interface. The reference interface may be provided as optical interface that couples to the optical conductive signal path via the respective signal port of the hybrid cable. The reference interface may also be provided as electrical interface. Such an electrical interface may couple to an electrical component in the respective signal port of the hybrid cable to exchange the respective data, wherein the electrical component may emit an optical signal into the optical conductive signal path, and may receive the reflected optical signal in order to determine respective calibration data.

The measurement application device may via that signal port input RF signals to or receive RF signals from the RF electrical conductive signal path that are exchange with any device, like a device under test, DUT, on the other signal port. At the same time, the measurement application device may input and receive an optical signal via the optical conductive signal path that is input by the measurement application device, reflected by the reflector, and received by the measurement application device.

The calibration parameter determination unit of the measurement application device may then, if not determined in the hybrid cable, use the reflected optical signal to determine calibration parameters for an RF signal path that is coupled to the signal port of the measurement application device, i.e., the hybrid cable with the first signal port, the second signal port, and the RF electrical conductive signal path.

Of course, prior to performing a measurement with RF signals, the signal path, i.e., from the measurement application device to a reference plane or to a point in the signal path prior to the DUT, may be calibrated.

As indicated above, HF cables influence the measurement by various properties, like adjustment at the ends, also called ports or connectors, polarization, and amplitude, frequency, and phase group runtime over frequency, over temperature, over move or strain, over time, and over age.

These properties are usually measured and taken into account during the calibration. However, since these parameters may change e.g., over time, over temperature, and over movement of the HF cable, the overall measurement result in the system deteriorates from the time of calibration, because the cable errors are different than at the time of calibration. This can be handled by calibrating more frequently. This, in turn, may take from hours to days for large structures.

With the hybrid cable according to the present disclosure it is possible to determine changes of the electrical parameters of the RF electrical conductive signal path based on changes in the optical signals measured via the optical conductive signal path.

The calibration parameter determination unit may to this end map any changes in the optical conductive signal path identified e.g., by comparing an optical signal injected into the optical conductive signal path with the reflected optical signal, to respective changes of the parameters or properties of the RF electrical conductive signal path.

"Mapping" the changes in this context may refer to determining an updated set of calibration parameters for the measurement application in which the measurement application device, and the hybrid cable are used, and applying these calibration parameters to further measurements. The newly determined calibration parameters may e.g., be added or applied to the formerly determined calibration parameters.

Thus, with the solution according to the present disclosure the changes in the cable properties or parameters may be tracked essentially in real time from the time of calibration.

A measurement application device according to the present disclosure may comprise any device that may be used in a measurement application to acquire an input signal or to generate an output signal, or to perform additional or supporting functions in a measurement application. A measurement application device may also comprise or be implemented as program application or program applications, also called measurement program application or measurement program applications, that may be executed on a computer device and that may communicate with other measurement application devices in order to perform a measurement task. A measurement application, also called measurement setup, may e.g., comprise at least one or multiple different measurement application devices for performing electric, magnetic, or electromagnetic measurements, especially on single devices under test. Such electric, magnetic, or electromagnetic measurements may e.g., be performed in a measurement laboratory or in a production facility in the respective production line. An exemplary measurement application or measurement setup may serve to qualify the single devices under test i.e., to determine the proper electrical operation of the respective devices under test.

Measurement application devices to this end may comprise at least one signal acquisition section for acquiring electric, magnetic, or electromagnetic signals to be measured from a device under test, or at least one signal generation section for generating electric, magnetic, or electromagnetic signals that may be provided to the device under test. Such a signal acquisition section may comprise, but is not limited to, a front-end for acquiring, filtering, and attenuating or amplifying electrical signals. The signal generation section may comprise, but is not limited to, respective signal generators, amplifiers, and filters. In embodiments, the signal acquisition is performed via the signal acquisition section in a wired or contact-based manner or fashion. To this end, a respective measurement probe may be coupled to the measurement application device via a respective cable. In embodiments, the signal generation and emission is performed via the signal generation section in a wired or contact-based manner or fashion. To this end, a respective signal output probe may be coupled to the measurement application device via a respective cable, or the signal may be output directly via the cable e.g., to a device under test.

Further, when acquiring signals, measurement application devices may comprise a signal processing section that may process the acquired signals. Processing may comprise converting the acquired signals from analog to digital signals, and any other type of digital signal processing, for example, converting signals from the time-domain into the frequency-domain.

The measurement application devices may also comprise a user interface to display the acquired signals to a user and allow a user to control the measurement application devices. Of course, a housing may be provided that comprises the elements of the measurement application device. It is understood, that further elements, like power supply circuitry, and communication interfaces may be provided.

A measurement application device may be a stand-alone device that may be operated without any further element in a measurement application to perform tests on a device under test. Of course, communication capabilities may also be provided for the measurement application device to interact with other measurement application devices.

A measurement application device may comprise, for example, a signal acquisition device e.g., an oscilloscope, especially a digital oscilloscope, a spectrum analyzer, or a vector network analyzer or combined devices for e.g. component tests. Such a measurement application device may also comprise a signal generation device e.g., a signal generator, especially an arbitrary signal generator, also called arbitrary waveform generator, or a vector signal generator. Further possible measurement application devices comprise devices like calibration standards, or measurement probe tips.

Of course, at least some of the possible functions, like signal acquisition and signal generation, may be combined in a single measurement application device.

In embodiments, the measurement application device may comprise pure data acquisition devices that are capable of acquiring an input signal and of providing the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

With the solution according to the present disclosure, it is possible to set-up measurement applications and systems that depend on high accuracy measurements, e.g., systems which are intended to transmit a clock to a plurality of devices with a known fixed phase, e.g. measuring systems that want to measure HF signals with many inputs and/or outputs in a phase-coherent manner or at least with a known phase change e.g., multi-antenna measurements or local oscillator sharing systems. This is not possible with other common setups.

Further, with the solution according to the present disclosure, the measurement accuracy in HF measurement applications may be kept essentially constant and as good as directly after calibration. Therefore, calibration intervals may be significantly extended or the number of calibrations may be reduced.

In addition, isolation efforts for providing temperature stabilization and mechanical decoupling of the cables may also be reduced.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to independent claim 1 can be combined in all variations with each other and the disclosure of the description is not limited to the claim dependencies as specified in the claim set. Further, the features of the dependent claims referring to independent claim 1 may be combined with any of the features of the other independent claims or the dependent claims relating to any one of the other independent claims. In a respective method, respective method steps may perform the function of the respective apparatus elements, and in a respective apparatus, respective apparatus elements may perform the respective method steps.

In an embodiment, which can be combined with all other embodiments mentioned above or below, the RF electrical conductive signal path comprises a conductor surrounded by a dielectric shielding.

Using a conductor, especially a solid conductor, such as a wire, as a kind or "inner" conductor, with a respective dielectric shielding surrounding the conductor provides for a simple mechanical arrangement of the hybrid cable that may easily be manufactured.

In a further embodiment, which can be combined with all other embodiments mentioned above or below, the hybrid cable may further comprise an electrical shielding that surrounds the dielectric shielding.

The electrical shielding together with the dielectric shielding, and the "inner" conductor forms a coaxial cable arrangement that may be used to transmit an RF signal.

In such an arrangement, the electrical shielding may be coupled to at least one of the first signal port or the second signal port of the hybrid cable. In a device coupled to the hybrid cable, the electrical shielding may be coupled e.g., to a ground plane. The electrical shielding, therefore, provides an electric shielding for the conductor.

In another embodiment, which can be combined with all other embodiments mentioned above or below, the RF electrical conductive signal path comprises a waveguide conductor.

Implementing the RF electrical conductive signal path as waveguide, especially as hollow waveguide conductor, allows applying the hybrid cable to a plurality of measurement applications that require a waveguide instead of a simple conductor.

In a further embodiment, which can be combined with all other embodiments mentioned above or below, the optical conductive signal path may comprise an optically conductive coating on the inside or the outside of the RF electrical conductive signal path.

As explained above, the optical conductive signal path may be provided in the form of a conductor, especially a solid conductor, or a waveguide conductor, especially a hollow waveguide conductor.

The optical conductive signal path is required to transport an optical signal, and may therefore be provided e.g., as an optically conductive coating i.e., a coating made of a material that conducts such an optical signal.

When used with a hollow waveguide conductor as RF electrical conductive signal path, the optical conductive signal path may be provided as a coating on the inside or the outside of the hollow waveguide conductor. When used with a solid conductor, like a wire, the optical conductive signal path may be provided on the outside of the RF electrical conductive signal path.

In a further embodiment, which can be combined with all other embodiments mentioned above or below, the optical conductive signal path comprises an optical fiber.

Using an optical fiber as optical conductive signal path allows easily providing the optical conductive signal path on any predetermined RF electrical conductive signal path.

The optical fiber may e.g., be provided alongside the element e.g., wire or waveguide, that forms the RF electrical conductive signal path. To this end, the optical fiber may be glued to the RF electrical conductive signal path, or may be included in e.g., the dielectric shielding or may be glued to the dielectric shielding.

In an embodiment, which can be combined with all other embodiments mentioned above or below, the optical conductive signal path is arranged at least one of in the RF electrical conductive signal path, on the outside of the RF electrical conductive signal path, and wound around the RF electrical conductive signal path.

The optical conductive signal path may be provided in any adequate arrangement to the RF electrical conductive signal path. As indicated above, such an arrangement may comprise the optical conductive signal path being provided in or on the inside of the RF electrical conductive signal path. The optical conductive signal path may also be provided on the outside of the RF electrical conductive signal path. On the outside, the optical conductive signal path may be wound around the RF electrical conductive signal path directly on the RF electrical conductive signal path or with other elements, like the dielectric shielding between the optical conductive signal path, and the RF electrical conductive signal path. The optical conductive signal path may also be integrated into or may be formed at least in part by the dielectric shielding.

In another embodiment, which can be combined with all other embodiments mentioned above or below, the hybrid cable my further comprise an optical polarization rotator arranged e.g., at the reflector, wherein the optical polarization rotator is configured to rotate the polarization of an optical signal that passes through the optical polarization rotator by a predetermined angle of rotation.

The optical polarization rotator may be used to rotate the polarization of an optical signal that is input on the end opposite to the reflector into the optical conductive signal path. At that end, the reflected optical signal will, therefore, arrive with a different polarization than it is input to the optical polarization rotator, and may, therefore, more easily be coupled out of the optical conductive signal path for further processing.

In a further embodiment, which can be combined with all other embodiments mentioned above or below, the reflector comprises the optical polarization rotator.

In an embodiment, which can be combined with all other embodiments mentioned above or below, the hybrid cable may further comprise a measurement unit arranged in the signal port opposite to the signal port that comprises the reflector, wherein the measurement unit is coupled to the optical conductive signal path, wherein the measurement unit comprises a light source, and a light receiver, and wherein the measurement unit is configured to emit an optical reference signal into the optical conductive signal path via the light source, and to receive the optical reference signal reflected by the reflector as reflected optical reference signal via the light receiver.

With the measurement unit, the hybrid cable may be provided with a kind of internal functionality that allows the hybrid cable to autonomously generate the optical reference signal, and receive the reflected version of the optical reference signal.

The emitted optical reference signal may be generated with the light source, while the reflected version of the optical reference signal may be received with the light receiver. The light receiver may e.g., output a respective electrical signal.

In embodiments, the light source, and the light receiver may both be coupled to respective connecting elements, also called connectors, of the respective signal port. These connecting elements may be used to couple the light source, and the light receiver with external circuitry e.g., circuitry for driving the light source, and for receiving signals from the light receiver.

Respective circuitry may be provided in the form of the reference interface of the measurement application device according to the present disclosure. In such embodiments, the measurement application device may comprise any required or adequate electronic circuitry for interfacing to at least the light source or the light receiver.

In another embodiment, which can be combined with all other embodiments mentioned above or below, the hybrid cable may further comprise a calibration parameter determination unit that is configured to determine at least one calibration parameter for the RF electrical conductive signal path based on the optical reference signal and the reflected optical reference signal.

The calibration parameter determination unit may comprise any kind of circuitry that may determine the at least one calibration parameter. Such circuitry may be analog, or digital, and may e.g., combine the emitted optical reference signal with the received optical reference signal in order to determine the at least one calibration parameter.

In a further embodiment, which can be combined with all other embodiments mentioned above or below, the optical reference signal may comprise a single optical signal or a plurality of optical signals with each optical signal comprising at least one of a specific wavelength, and a specific polarization.

The option to use different types and also a plurality of optical signals in the optical reference signal, allows adapting the measurement or acquisition of the data regarding changes of physical parameters in the surrounding of the RF electrical conductive signal path to different situations, and requirements regarding the quality and accuracy of the calibration.

In an embodiment, which can be combined with all other embodiments mentioned above or below, the measurement unit may further comprise a digital data interface configured to at least one of output at least one of measurement data regarding the reflected optical reference signal, and calibration data calculated based on the reflected optical reference signal, and receive at least one of control data for controlling generation and emission of the optical reference signal, and calibration input data for calculating the calibration data.

In another embodiment, which can be combined with all other embodiments mentioned above or below, the measurement application device may further comprise a sacrifice adapter that comprises a device-side signal port with an RF interface, and a reference interface, and that comprises a cable-side signal port with an RF interface, and a reference interface, wherein the device-side signal port is coupled to the signal port, and wherein the cable-side signal port is couplable to the hybrid cable.

The sacrifice adapter may be provided on the measurement application device that performs the determination of the calibration parameters. The hybrid cable is then coupled to the sacrifice adapter. In addition or as alternative, a sacrifice adapter may be provided between the hybrid cable and any device e.g., the device under test, on the other end of the hybrid cable.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a hybrid cable according to the present disclosure;
Figure 2 shows a block diagram of another embodiment of a hybrid cable according to the present disclosure;
Figure 3 shows a block diagram of a further embodiment of a hybrid cable according to the present disclosure;
Figure 4 shows a block diagram of another embodiment of a hybrid cable according to the present disclosure;
Figure 5 shows a block diagram of a further embodiment of a hybrid cable according to the present disclosure;
Figure 6 shows a block diagram of another embodiment of a hybrid cable according to the present disclosure;
Figure 7 shows a block diagram of a further embodiment of a hybrid cable according to the present disclosure;
Figure 8 shows a block diagram of an embodiment of a measurement application device according to the present disclosure;
Figure 9 shows a block diagram of a further embodiment of a hybrid cable according to the present disclosure;
Figure 10 shows a block diagram of another embodiment of a measurement application device according to the present disclosure; and
Figure 11 shows a block diagram of a further embodiment of a measurement application device according to the present disclosure.

In the figures like reference signs denote like elements unless stated otherwise.

### DETAILED DESCRIPTION OF THE DRAWINGS

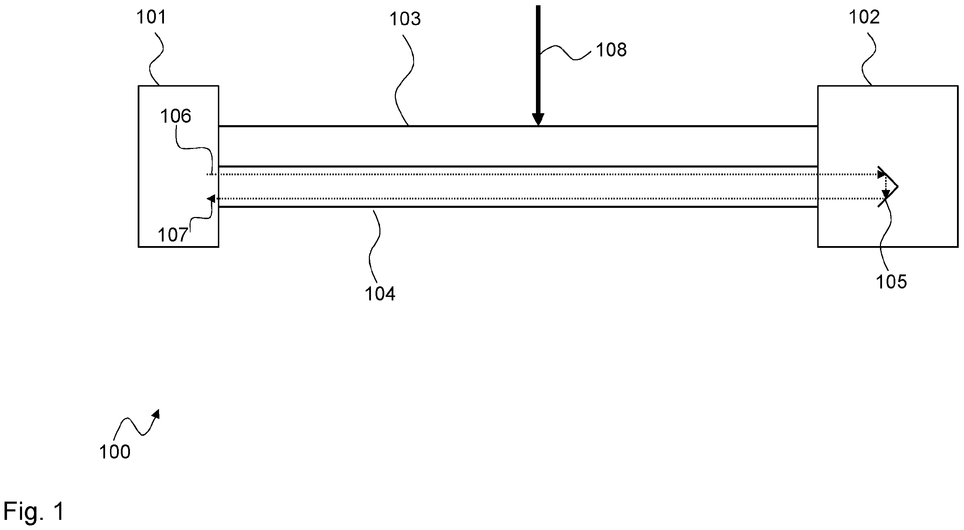

Figure 1 shows a hybrid cable 100. The hybrid cable 100 comprises a first signal port 101, and a second signal port 102. An RF electrical conductive signal path 103 is coupled to the first signal port 101, and the second signal port 102. Further, an optical conductive signal path 104 is arranged along the RF electrical conductive signal path 103. In addition, a reflector 105 is exemplarily arranged in the second signal port 102. The optical conductive signal path 104 is coupled to the reflector 105 and to the first signal port 101. In other embodiments, the reflector 105 may also be provided in the first signal port 101. The explanations provided herein for any other embodiment of the hybrid cable also apply mutatis mutandis to hybrid cable 100.

The optical conductive signal path 104 is provided such that changes of at least one physical parameter 108 of the RF electrical conductive signal path 103, like temperature or movement, also affect the optical conductive signal path 104. The expression "affect the optical conductive signal path 104" refers to changes of the physical parameter 108 affecting the RF electrical conductive signal path 103 also affecting the optical conductive signal path 104 such that the changes of the physical parameter 108 may at least qualitatively be determined.

This determination may be performed based on an optical reference signal 106 that is emitted into the optical conductive signal path 104, and a reflected optical reference signal 107 that is the optical reference signal 106 reflected by the reflector 105 in the second signal port 102.

Although not explained in more detail, it is understood that in an embodiment that may be combined with any other embodiment of the hybrid cable disclosed herein, the first signal port 101 and/or the second signal port 102 may both be provided as an integrated electrical/optical connector or coupler, or as two separate or dedicated connectors or couplers, one electrical and one optical.

The electrical connector part of an integrated electrical/optical connector or coupler, or the dedicated electrical connector or coupler may e.g., comprise a BNC-type or any other type of connector, e.g. ,1 mm coaxial-type connector or coupler.

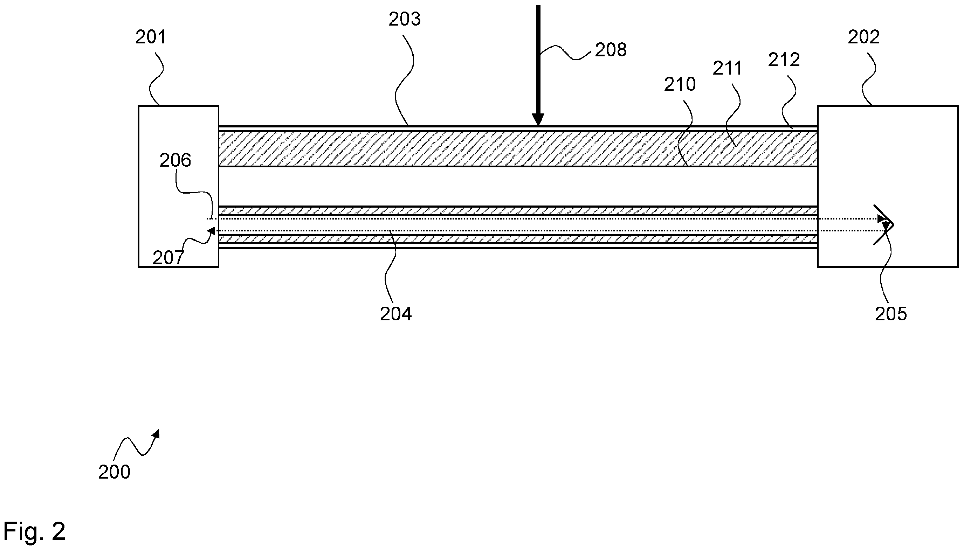

Figure 2 shows a block diagram of a hybrid cable 200. The hybrid cable 200 is based on the hybrid cable 100. Therefore, the hybrid cable 200 comprises a first signal port 201, and a second signal port 202. An RF electrical conductive signal path 203 is coupled to the first signal port 201, and the second signal port 202. Further, an optical conductive signal path 204 is arranged along the RF electrical conductive signal path 203. In addition, a reflector 205 is exemplarily arranged in the second signal port 202. The optical conductive signal path 204 is coupled to the reflector 205 and to the first signal port 201. In other embodiments, the reflector 205 may also be provided in the first signal port 201. The explanations provided herein for any other embodiment of the hybrid cable also apply mutatis mutandis to hybrid cable 200.

In the hybrid cable 200, the RF electrical conductive signal path 203 comprises a conductor 210 that is surrounded by a dielectric shielding 211 (shown with dashed lines in the sectional view). The dielectric shielding 211 is surrounded by an electrical shielding 212. The conductor 210 with the dielectric shielding 211, and the electrical shielding 212 together form a kind of coaxial cable.

In the hybrid cable 200, the optical conductive signal path 204 is provided in or inlaid into the dielectric shielding 211. The dielectric shielding 211 may exemplarily comprise a plastic material, and the optical conductive signal path 204 may be provided as an optical plastic or glass fiber in the plastic material. The optical conductive signal path 204 may also be embodied by the dielectric shielding 211.

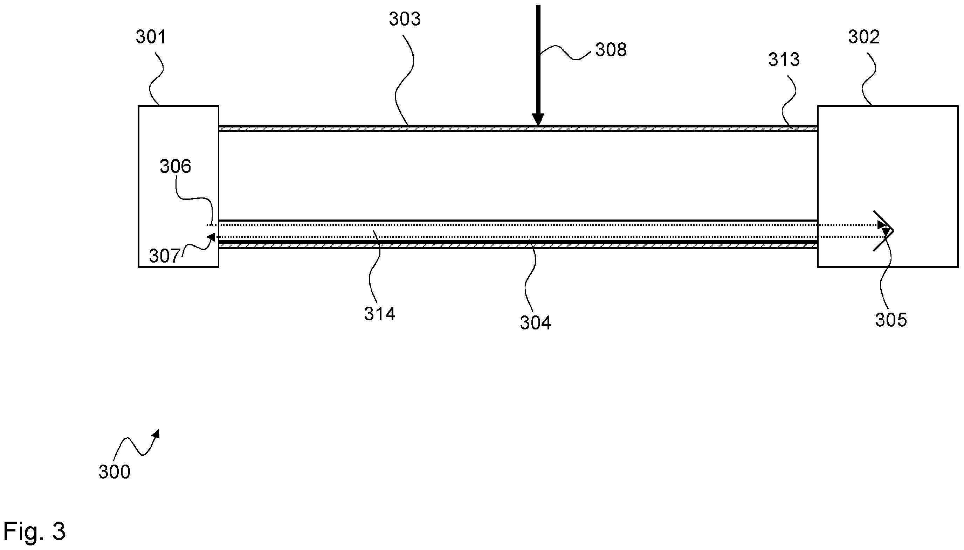

Figure 3 shows a block diagram of a hybrid cable 300. The hybrid cable 300 is based on the hybrid cable 100. Therefore, the hybrid cable 300 comprises a first signal port 301, and a second signal port 302. An RF electrical conductive signal path 303 is coupled to the first signal port 301, and the second signal port 302. Further, an optical conductive signal path 304 is arranged along the RF electrical conductive signal path 303. In addition, a reflector 305 is exemplarily arranged in the second signal port 302. The optical conductive signal path 304 is coupled to the reflector 305 and to the first signal port 301. In other embodiments, the reflector 305 may also be provided in the first signal port 301. The explanations provided herein for any other embodiment of the hybrid cable also apply mutatis mutandis to hybrid cable 300.

In the hybrid cable 300, the RF electrical conductive signal path 303 comprises a waveguide conductor 313, especially a hollow waveguide conductor. The waveguide conductor 313 may be provided e.g., as a hollow metallic tube-like element with a rectangular or any other shaped cross section.

The optical conductive signal path 304 in the exemplary embodiment of the hybrid cable 300 is provided on the lower bottom of the RF electrical conductive signal path 303 and may examplarily be provided as an optical fiber or an optically conductive coating 314.

In embodiments, the RF electrical conductive signal path 303 may be provided on other sections or sides of the RF electrical conductive signal path 303. If provided as an optically conductive coating 314, the optical conductive signal path 304 may also be provided fully covering the inner wall of the waveguide conductor 313.

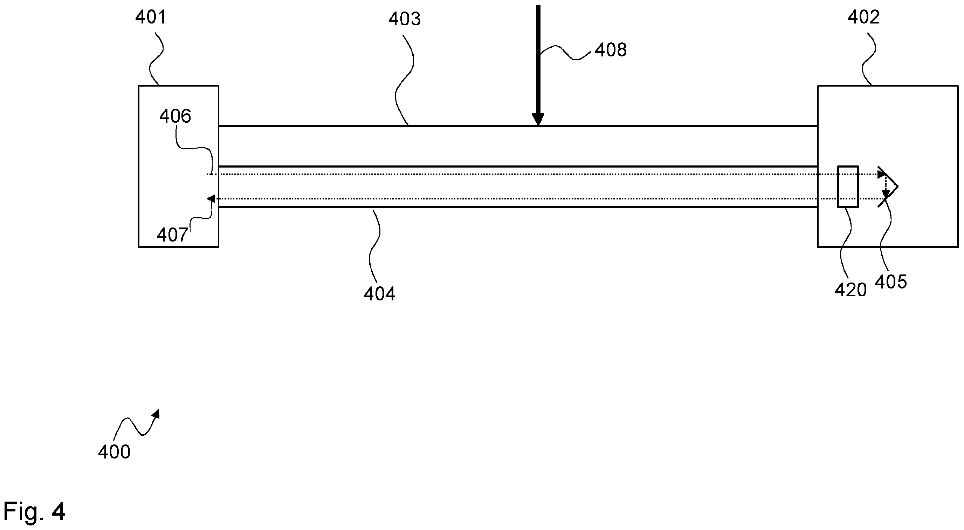

Figure 4 shows a block diagram of a hybrid cable 400. The hybrid cable 400 is based on the hybrid cable 100. Therefore, the hybrid cable 400 comprises a first signal port 401, and a second signal port 402. An RF electrical conductive signal path 403 is coupled to the first signal port 401, and the second signal port 402. Further, an optical conductive signal path 404 is arranged along the RF electrical conductive signal path 403. In addition, a reflector 405 is exemplarily arranged in the second signal port 402. The optical conductive signal path 404 is coupled to the reflector 405 and to the first signal port 401. In other embodiments, the reflector 405 may also be provided in the first signal port 401. The explanations provided herein for any other embodiment of the hybrid cable also apply mutatis mutandis to hybrid cable 400.

In the hybrid cable 400, the second signal port 402 comprises an optical polarization rotator 420. The optical reference signal 406 after traversing the optical conductive signal path 404 traverses the optical polarization rotator 420. The optical polarization rotator 420 rotates the polarization of the optical reference signal 406 by a predefined angle, such that the reflected optical reference signal 407 arrives at the first signal port 401 with a polarization that is rotated by a predetermined angle with regard to the polarization of the optical reference signal 406.

In embodiments, the optical polarization rotator 420 may be arranged such that the optical reference signal 406 traverses the optical polarization rotator 420 or such that the polarization is changed prior to arriving at the reflector 405, and after being reflected by the reflector 405. In other embodiments, the optical polarization rotator 420 may be arranged such that the optical reference signal 406 traverses the optical polarization rotator 420 or such that the polarization is changed only prior to arriving at the reflector 405, or after being reflected by the reflector 405.

The reflector 405 and the optical polarization rotator 420 may in embodiments also be provided as a single element.

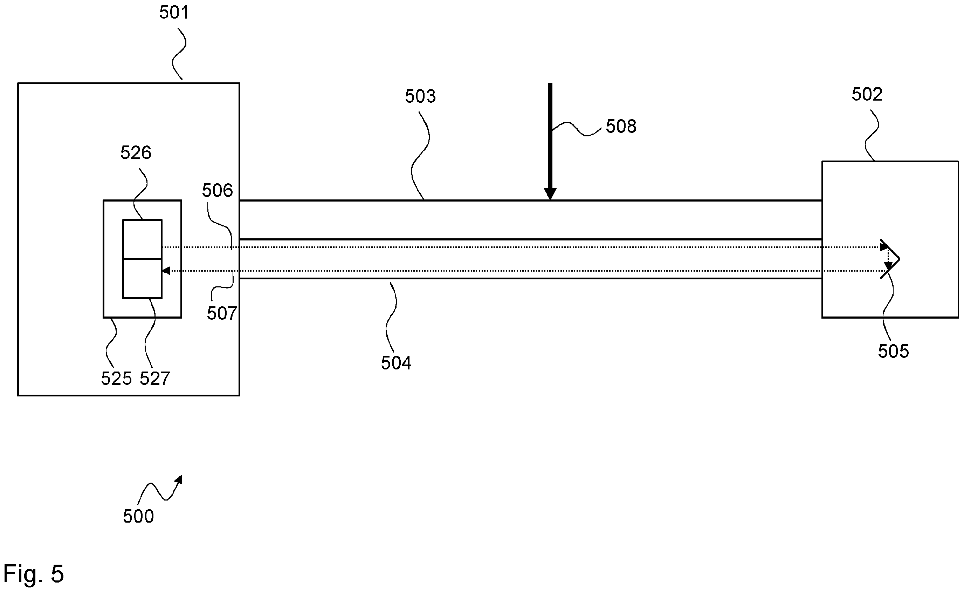

Figure 5 shows a block diagram of a hybrid cable 500. The hybrid cable 500 is based on the hybrid cable 100. Therefore, the hybrid cable 500 comprises a first signal port 501, and a second signal port 502. An RF electrical conductive signal path 503 is coupled to the first signal port 501, and the second signal port 502. Further, an optical conductive signal path 504 is arranged along the RF electrical conductive signal path 503. In addition, a reflector 505 is exemplarily arranged in the second signal port 502. The optical conductive signal path 504 is coupled to the reflector 505 and to the first signal port 501. In other embodiments, the reflector 505 may also be provided in the first signal port 501. The explanations provided herein for any other embodiment of the hybrid cable also apply mutatis mutandis to hybrid cable 500.

In the hybrid cable 500, a measurement unit 525 is provided in the first signal port 501. The measurement unit 525 may in other embodiments also be provided in the second signal port 502. Generally, the measurement unit 525 may be provided in the signal port opposite to the signal port that comprises the reflector 505.

The measurement unit 525 comprises a light source 526, and a light receiver 527, and emits an optical reference signal 506 into the optical conductive signal path 504 via the light source 526. Further, the measurement unit 525 receives the optical reference signal 506 reflected by the reflector 505 as reflected optical reference signal 507 via the light receiver 527.

Although not explicitly shown, the measurement unit 525 may comprise any kind of adequate interface, like an analog or digital interface, to couple to the light source 526, and the light receiver 527. The term light source 526 in this context may refer to a passive element, like a LED or laser source. The term light source 526 may also refer to a system comprising such a passive element together with any adequate or required driving circuitry. Likewise, the term light receiver 527 in this context may refer to a passive element, like a light sensor. The term light receiver 527 may also refer to a system comprising such a passive element together with any adequate or required driving circuitry.

With the measurement unit 525 the hybrid cable 500 may be formed as a kind of self-contained or self-calibrating hybrid cable 500.

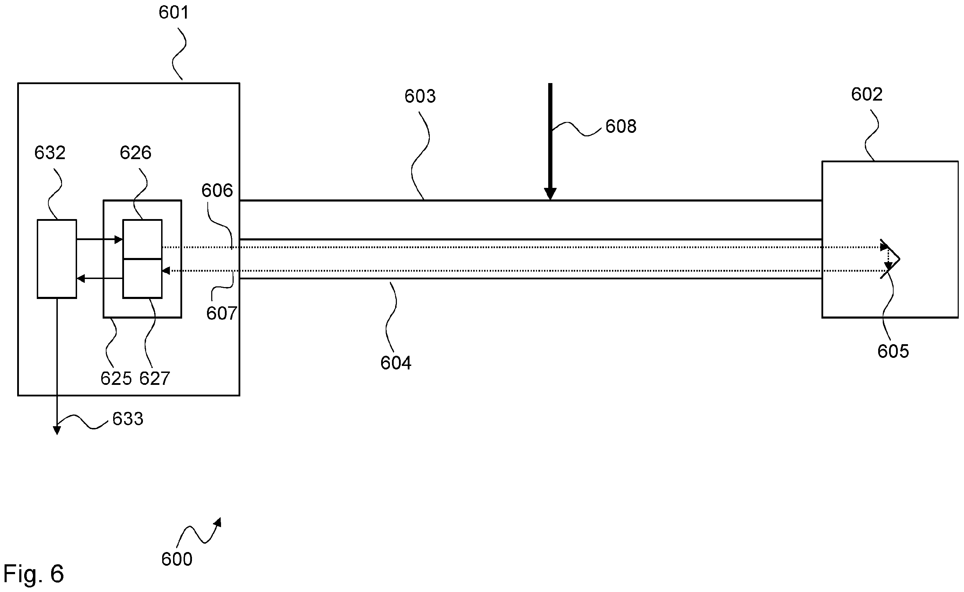

Figure 6 shows a block diagram of a hybrid cable 600. The hybrid cable 600 is based on the hybrid cable 500. Therefore, the hybrid cable 600 comprises a first signal port 601, and a second signal port 602. An RF electrical conductive signal path 603 is coupled to the first signal port 601, and the second signal port 602. Further, an optical conductive signal path 604 is arranged along the RF electrical conductive signal path 603. In addition, a reflector 605 is exemplarily arranged in the second signal port 602. The optical conductive signal path 604 is coupled to the reflector 605 and to the first signal port 601. In other embodiments, the reflector 605 may also be provided in the first signal port 601. The hybrid cable 600 further comprises a measurement unit 625 that is provided in the first signal port 601 . The measurement unit 625 comprises a light source 626, and a light receiver 627. The explanations provided herein for any other embodiment of the hybrid cable also apply mutatis mutandis to hybrid cable 600.

In the hybrid cable 600, the first signal port 601 further comprises a calibration parameter determination unit 632 that is communicatively coupled to the measurement unit 625. The measurement unit 625 may comprise a computing element, like a processor, and respective driving circuitry to operate or communicate with the measurement unit 625, i.e., the light source 626, and the light receiver 627.

The calibration parameter determination unit 632 in conjunction with the measurement unit 625, i.e. with the light source 626, and the light receiver 627, may determine changes of the RF electrical conductive signal path 603 that may be caused by the physical parameter 608. The calibration parameter determination unit 632 may output a pure measurement signal as determined via the light receiver 627 based on the reflected optical reference signal 607 as calibration parameter 633. In embodiments, the calibration parameter determination unit 632 may calculate calibration values, like s-parameters, group delays, phase delays for the RF electrical conductive signal path 603 based on the reflected optical reference signal 607.

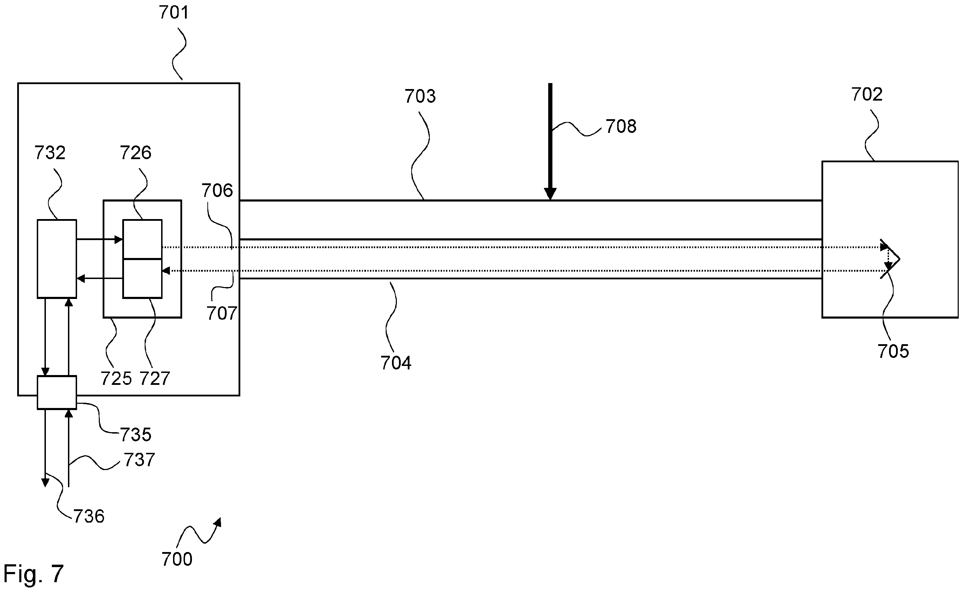

Figure 7 shows a block diagram of a hybrid cable 700. The hybrid cable 700 is based on the hybrid cable 600. Therefore, the hybrid cable 700 comprises a first signal port 701, and a second signal port 702. An RF electrical conductive signal path 703 is coupled to the first signal port 701, and the second signal port 702. Further, an optical conductive signal path 704 is arranged along the RF electrical conductive signal path 703. In addition, a reflector 705 is exemplarily arranged in the second signal port 702. The optical conductive signal path 704 is coupled to the reflector 705 and to the first signal port 701. In other embodiments, the reflector 705 may also be provided in the first signal port 701. The hybrid cable 700 further comprises a measurement unit 725 that is provided in the first signal port 701 . The measurement unit 725 comprises a light source 726, and a light receiver 727. Further, the measurement unit 725 is coupled to a calibration parameter determination unit 732. The explanations provided herein for any other embodiment of the hybrid cable also apply mutatis mutandis to hybrid cable 700.

The calibration parameter determination unit 732 may e.g., output the calibration parameter mentioned above via digital data interface 735. Generally, the calibration parameter determination unit 732 may output measurement data 736 regarding the reflected optical reference signal 707, and calibration data 736 calculated based on the reflected optical reference signal 707. The calibration parameter determination unit 732 may also receive at least one of control data 737 for controlling generation and emission of the optical reference signal 706, and calibration input data 737 for calculating the calibration data 736.

The digital data interface 735 may e.g., comprise a digital interface, like a USB interface, an SPI interface, or a wireless interface e.g., an NFC interface.

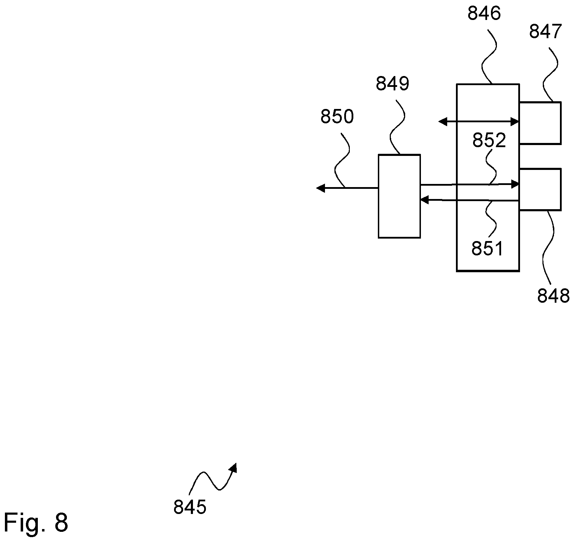

Figure 8 shows a block diagram of a measurement application device 845. The measurement application device 845 comprises a signal port 846 with an RF interface 847, and with a reference interface 848. Further, the measurement application device 845 comprises a calibration parameter determination unit 849. The signal port 846 is couplable to any embodiment of a hybrid cable 100, 200, 300, 400, 500, 600, 700 as disclosed herein. Further, the calibration parameter determination unit 849 determines at least one calibration parameter 850 for an RF signal path coupled to the RF interface 847 of the signal port 846 based on an input signal 851 that is received via the reference interface 848 in response to a calibration signal 852 being output via the reference interface 848 of the signal port 846. The input signal 851, and the calibration signal 852 may be provided as optical signals.

Determining the calibration parameter 850 may be performed in any form of cooperation between the calibration parameter determination unit 849 and the hybrid cable, e.g., between the calibration parameter determination unit 849, and the calibration parameter determination unit mentioned above.

Although not explicitly shown, the measurement application device 845 may comprise further measurement interfaces, control interfaces and user interfaces, like usually present e.g., in oscilloscopes or vector network analyzers. Further, measurement elements or data processing elements may use the calibration parameter 850 to calibrate or correct the measurements performed by the measurement application device 845.

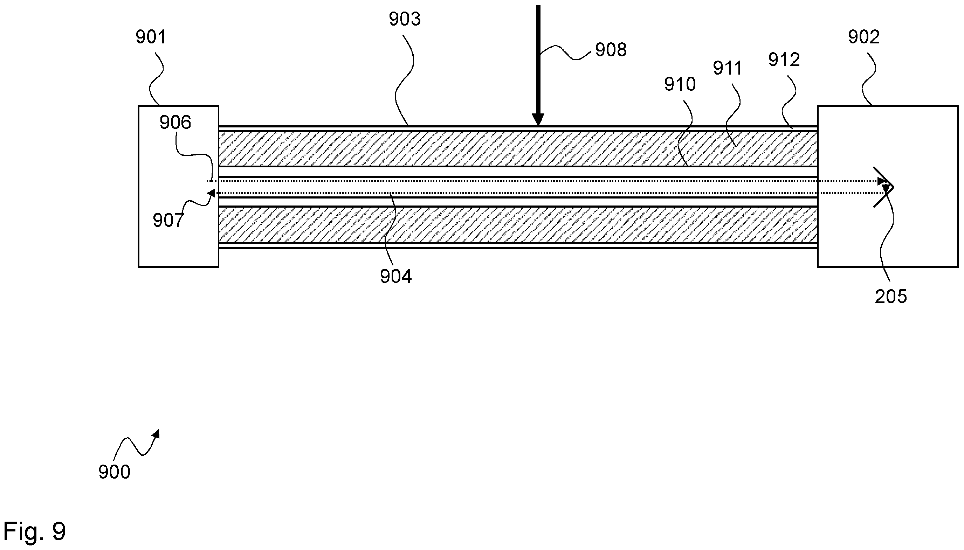

Figure 9 shows a block diagram of a hybrid cable 900. The hybrid cable 900 is based on the hybrid cable 200. Therefore, the hybrid cable 900 comprises a first signal port 901, and a second signal port 902. An RF electrical conductive signal path 903 is coupled to the first signal port 901, and the second signal port 902. Further, an optical conductive signal path 904 is arranged along the RF electrical conductive signal path 903. In addition, a reflector 905 is exemplarily arranged in the second signal port 902. The optical conductive signal path 904 is coupled to the reflector 905 and to the first signal port 901. In other embodiments, the reflector 905 may also be provided in the first signal port 901. The explanations provided herein for any other embodiment of the hybrid cable also apply mutatis mutandis to hybrid cable 900.

In the hybrid cable 900, the RF electrical conductive signal path 903 comprises a conductor 910 that is surrounded by a dielectric shielding 911 (shown with dashed lines in the sectional view). The dielectric shielding 911 is surrounded by an electrical shielding 912. The conductor 910 with the dielectric shielding 911, and the electrical shielding 912 together form a kind of coaxial cable.

In the hybrid cable 900, the optical conductive signal path 904 is provided in or inlaid into the conductor 910. The conductor 910 may exemplarily comprise a metallic or conductive braid and the optical conductive signal path 904 may be provided as an optical plastic or glass fiber in the braid.

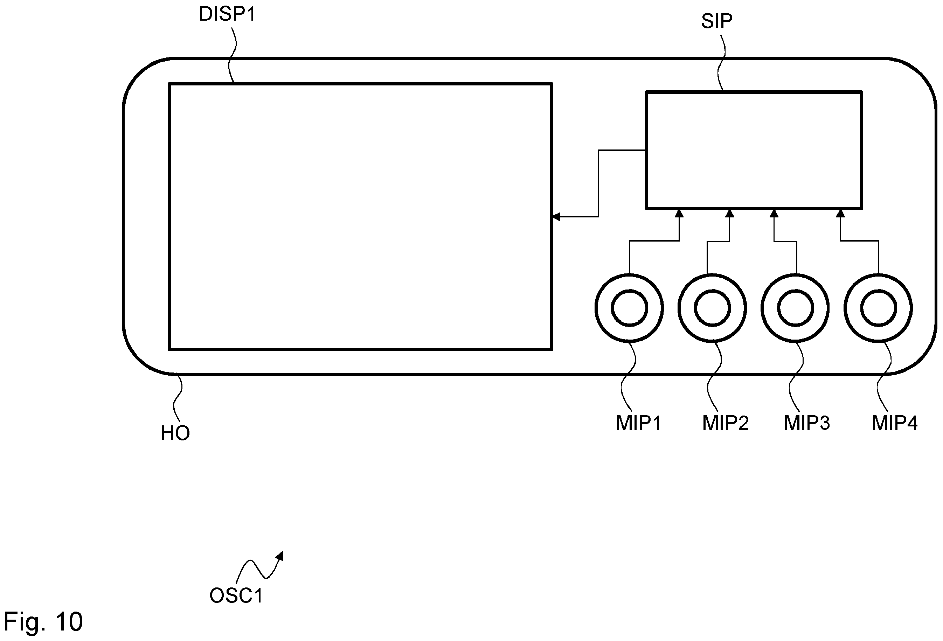

Figure 10 shows a block diagram of an oscilloscope OSC1 that may be used with an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

Although not explicitly shown, it is understood, that the oscilloscope OSC1 may also comprise signal outputs. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In the oscilloscope OSC1 the signal processor SIP or an additional processing element may perform the function of the calibration parameter determination unit 849 or the measurement application device 845 according to the present disclosure, or may implement the calibration parameter determination unit 849 or the measurement application device 845. Of course, a communication interface may be provided in the oscilloscope OSC1 for communication with other measurement application devices.

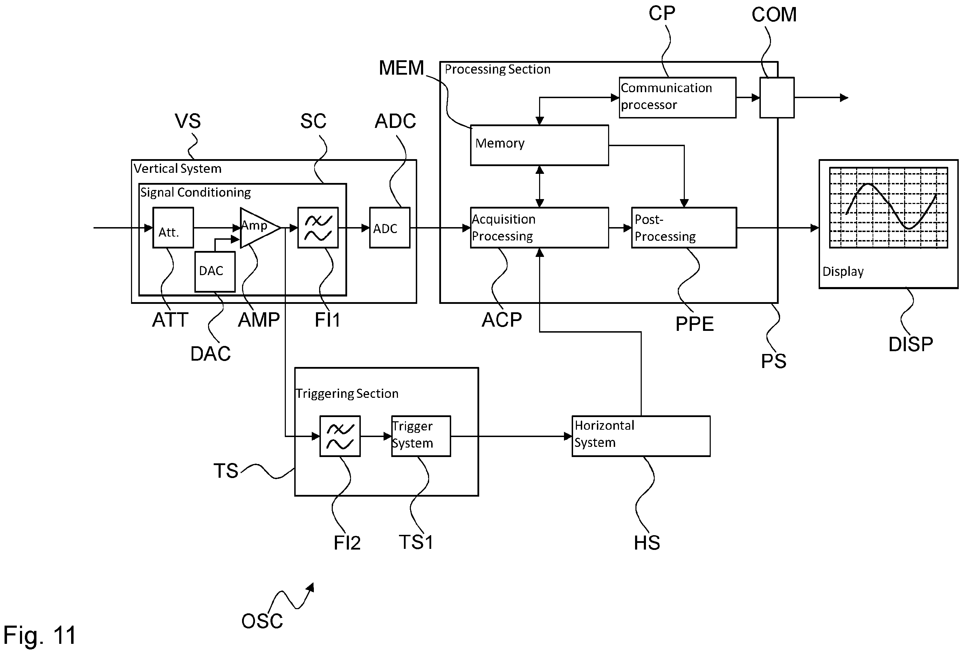

Figure 11 shows a block diagram of an oscilloscope OSC that may be an implementation of a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS and the display DISP. It is understood, that the partitioning into five general sections is a logical partitioning and does not limit the placement and implementation of any of the elements of the oscilloscope OSC in any way.

The vertical system VS mainly serves for offsetting, attenuating and amplifying a signal to be acquired. The signal may for example be modified to fit in the available space on the display DISP or to comprise a vertical size as configured by a user.

To this end, the vertical system VS comprises a signal conditioning section SC with an attenuator ATT and a digital-to-analog-converter DAC that are coupled to an amplifier AMP. The amplifier AMP is coupled to a filter FI1, which in the shown example is provided as a low pass filter. The vertical system VS also comprises an analog-to-digital converter ADC that receives the output from the filter FI1 and converts the received analog signal into a digital signal.

The attenuatorATT and the amplifier AMP serve to scale the amplitude of the signal to be acquired to match the operation range of the analog-to-digital converter ADC. The digital-to-analog-converter DAC serves to modify the DC component of the input signal to be acquired to match the operation range of the analog-to-digital converter ADC. The filter FI1 serves to filter out unwanted high frequency components of the signal to be acquired.

The triggering section TS operates on the signal as provided by the amplifier AMP. The triggering section TS comprises a filter FI2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

In order to allow an exact matching of the trigger event and the waveform that is shown on the display DISP, a common time base may be provided for the analog-to-digital converter ADC and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the amplifier AMP but will operate on the digital signal as provided by the analog-to-digital converter ADC.

A digital triggering section may comprise a processing element, like a processor, a DSP, a CPLD, an ASIC or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC and the output of the horizontal system HS as well as to a memory MEM and a post processing element PPE.

The acquisition processing element ACP manages the acquisition of digital data from the analog-to-digital converter ADC and the storage of the data in the memory MEM. The acquisition processing element ACP may for example comprise a processing element with a digital interface to the analog-to-digital converter ADC2 and a digital interface to the memory MEM. The processing element may for example comprise a microcontroller, a DSP, a CPLD, an ASIC or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA opposed to software being executed by a processor.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infrared communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user. The post processing element PPE may also realize analysis functions like cursors, waveform measurements, histograms, or math functions.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

In the oscilloscope OSC, any one of the processing elements in the processing section PS or an additional processing element may perform the function of the calibration parameter determination unit 849 or the measurement application device 845 according to the present disclosure.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

The processes, methods, or algorithms disclosed herein can be deliverable to/implemented by a processing device, controller, or computer, which can include any existing programmable electronic control unit or dedicated electronic control unit.

Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### LIST OF REFERENCE SIGNS

- 100, 200, 300, 400, 500, 600, 700, 900: hybrid cable
- 101, 201, 301, 401, 501, 601, 701, 901: first signal port
- 102, 202, 302, 402, 502, 602, 702, 902: second signal port
- 103, 203, 303, 403, 503, 603, 703, 903: RF electrical conductive signal path
- 104, 204, 304, 404, 504, 604, 704, 904: optical conductive signal path
- 105, 205, 305, 405, 505, 605, 705, 905: reflector
- 106, 206, 306, 406, 506, 606, 706, 906: optical reference signal
- 107, 207, 307, 407, 507, 607, 707, 907: reflected optical reference signal
- 108, 208, 308, 408, 508, 608, 708, 908: physical parameter
- 210, 910: conductor
- 211, 911: dielectric shielding
- 212, 912: electrical shielding
- 313: waveguide conductor
- 314: optically conductive coating
- 420: optical polarization rotator
- 525, 625, 725: measurement unit
- 526, 626, 726: light source
- 527, 627, 727: light receiver
- 632, 732: calibration parameter determination unit
- 633: calibration parameter
- 735: digital data interface
- 736: measurement data / calibration data
- 737: control data / calibration input data
- 845: measurement application device
- 846: signal port
- 847: RF interface
- 848: reference interface
- 849: calibration parameter determination unit
- 850: calibration parameter
- 851: input signal
- 852: calibration signal
- OSC1: oscilloscope
- HO: housing
- MIP1, MIP2, MIP3, MIP4: measurement input
- SIP: signal processing
- DISP1: display
- OSC: oscilloscope
- VS: vertical system
- SC: signal conditioning
- ATT: attenuator
- DAC1: analog-to-digital converter
- AMP: amplifier
- Fl1: filter
- DAC: digital-to-analog converter
- ADC: analog-to-digital converter
- TS: triggering section
- AMP2: amplifier
- FI2: filter
- TS1: trigger system
- HS: horizontal system
- PS: processing section
- ACP: acquisition processing element
- MEM: memory
- PPE: post processing element
- DISP: display

## Claims

1. Hybrid cable (100, 200, 300, 400, 500, 600, 700, 900) comprising:
a first signal port (101, 201, 301, 401, 501, 601, 701, 901);
a second signal port (102, 202, 302, 402, 502, 602, 702, 902);
an RF electrical conductive signal path (103, 203, 303, 403, 503, 603, 703, 903) coupled to the first signal port (101, 201, 301, 401, 501, 601, 701, 901), and the second signal port (102, 202, 302, 402, 502, 602, 702, 902);
an optical conductive signal path (104, 204, 304, 404, 504, 604, 704, 904) arranged along the RF electrical conductive signal path (103, 203, 303, 403, 503, 603, 703, 903) such that changes of at least one physical parameter (108, 208, 308, 408, 508, 608, 708, 908) of the RF electrical conductive signal path (103, 203, 303, 403, 503, 603, 703, 903) also affect the optical conductive signal path (104, 204, 304, 404, 504, 604, 704, 904); and
a reflector (105, 205, 305, 405, 505, 605, 705, 905) arranged in the first signal port (101, 201, 301, 401, 501, 601, 701, 901) or the second signal port (102, 202, 302, 402, 502, 602, 702, 902);
wherein the optical conductive signal path (104, 204, 304, 404, 504, 604, 704, 904) is coupled to the reflector (105, 205, 305, 405, 505, 605, 705, 905) and to the signal port (101, 201, 301, 401, 501, 601, 701, 901) that is opposite to the signal port (102, 202, 302, 402, 502, 602, 702, 902) that comprises the reflector (105, 205, 305, 405, 505, 605, 705, 905).

2. Hybrid cable (100, 200, 300, 400, 500, 600, 700, 900) according to claim 1, wherein the RF electrical conductive signal path (103, 203, 303, 403, 503, 603, 703, 903) comprises a conductor (210, 910) surrounded by a dielectric shielding (211, 911).

3. Hybrid cable (100, 200, 300, 400, 500, 600, 700, 900) according to claim 2, further comprising an electrical shielding (212, 912) that surrounds the dielectric shielding (211, 911).

4. Hybrid cable (100, 200, 300, 400, 500, 600, 700, 900) according to claim 1, wherein the RF electrical conductive signal path (103, 203, 303, 403, 503, 603, 703, 903) comprises a waveguide conductor (313).

5. Hybrid cable (100, 200, 300, 400, 500, 600, 700, 900) according to any one of the preceding claims, wherein the optical conductive signal path (104, 204, 304, 404, 504, 604, 704, 904) comprises an optically conductive coating (314) on the inside or the outside of the RF electrical conductive signal path (103, 203, 303, 403, 503, 603, 703, 903).

6. Hybrid cable (100, 200, 300, 400, 500, 600, 700, 900) according to any one of the preceding claims, wherein the optical conductive signal path (104, 204, 304, 404, 504, 604, 704, 904) comprises an optical fiber.

7. Hybrid cable (100, 200, 300, 400, 500, 600, 700, 900) according to any one of the preceding claims, wherein the optical conductive signal path (104, 204, 304, 404, 504, 604, 704, 904) is arranged at least one of in the RF electrical conductive signal path (103, 203, 303, 403, 503, 603, 703, 903), on the outside of the RF electrical conductive signal path (103, 203, 303, 403, 503, 603, 703, 903), and wound around the RF electrical conductive signal path (103, 203, 303, 403, 503, 603, 703, 903).

8. Hybrid cable (100, 200, 300, 400, 500, 600, 700, 900) according to any one of the preceding claims, further comprising an optical polarization rotator (420) arranged at the reflector (105, 205, 305, 405, 505, 605, 705, 905), wherein the optical polarization rotator (420) is configured to rotate the polarization of an optical signal that passes through the optical polarization rotator (420) by a predetermined angle of rotation.

9. Hybrid cable (100, 200, 300, 400, 500, 600, 700, 900) according to any one of the preceding claims, wherein the reflector (105, 205, 305, 405, 505, 605, 705, 905) comprises the optical polarization rotator (420) .

10. Hybrid cable (100, 200, 300, 400, 500, 600, 700, 900) according to any one of the preceding claims, further comprising a measurement unit (525, 625, 725) arranged in the signal port (101, 201, 301, 401, 501, 601, 701, 901) opposite to the signal port (102, 202, 302, 402, 502, 602, 702, 902)that comprises the reflector (105, 205, 305, 405, 505, 605, 705, 905), wherein the measurement unit (525, 625, 725) is coupled to the optical conductive signal path (104, 204, 304, 404, 504, 604, 704, 904) ;
wherein the measurement unit (525, 625, 725) comprises a light source (526, 626, 726), and a light receiver (527, 627, 727); and
wherein the measurement unit (525, 625, 725) is configured:
to emit an optical reference signal (106, 206, 306, 406, 506, 606, 706, 906) into the optical conductive signal path (104, 204, 304, 404, 504, 604, 704, 904) via the light source (526, 626, 726), and
to receive the optical reference signal (106, 206, 306, 406, 506, 606, 706, 906) reflected by the reflector (105, 205, 305, 405, 505, 605, 705, 905) as reflected optical reference signal (107, 207, 307, 407, 507, 607, 707, 907) via the light receiver (527, 627, 727).

11. Hybrid cable (100, 200, 300, 400, 500, 600, 700, 900) according to claim 10, further comprising a calibration parameter determination unit (632, 732) that is configured to determine at least one calibration parameter (633) for the RF electrical conductive signal path (103, 203, 303, 403, 503, 603, 703, 903) based on the optical reference signal (106, 206, 306, 406, 506, 606, 706, 906) and the reflected optical reference signal (107, 207, 307, 407, 507, 607, 707, 907).

12. Hybrid cable (100, 200, 300, 400, 500, 600, 700, 900) according to any one of claims 10 and 11, wherein the optical reference signal (106, 206, 306, 406, 506, 606, 706, 906) comprises a single optical signal or a plurality of optical signals with each optical signal comprising at least one of a specific wavelength, and a specific polarization.

13. Hybrid cable (100, 200, 300, 400, 500, 600, 700, 900) according to any one of claims 10 to 12, wherein the measurement unit (525, 625, 725) further comprises a digital data interface (735) configured to at least one of:
output at least one of measurement data (736) regarding the reflected optical reference signal (107, 207, 307, 407, 507, 607, 707, 907), and calibration data (736) calculated based on the reflected optical reference signal (107, 207, 307, 407, 507, 607, 707, 907); and
receive at least one of control data (737) for controlling generation and emission of the optical reference signal (106, 206, 306, 406, 506, 606, 706, 906), and calibration input data (737) for calculating the calibration data (736).

14. Measurement application device (845) comprising:
a signal port (846) with an RF interface (847), and with a reference interface (848); and
a calibration parameter determination unit (849);
wherein the signal port (846) is couplable to a hybrid cable (100, 200, 300, 400, 500, 600, 700, 900) according to any one the preceding claims; and
wherein the calibration parameter determination unit (849) is configured to determine at least one calibration parameter (850) for an RF signal path coupled to the RF interface (847) of the signal port (846) based on an input signal (851) that is received via the reference interface (848) in response to a calibration signal (852) being output via the reference interface (848) of the signal port (846).

15. Measurement application device according to claim 14, further comprising a sacrifice adapter that comprises a device-side signal port with an RF interface, and a reference interface, and that comprises a cable-side signal port with an RF interface, and a reference interface;
wherein the device-side signal port is coupled to the signal port; and
wherein the cable-side signal port is couplable to the hybrid cable (100, 200, 300, 400, 500, 600, 700, 900).
